(19) Europäisches Patentamt

European Patent Office

Office européen des brevets

(11) **EP 1 646 143 A1**

(12) **EUROPEAN PATENT APPLICATION**

(43) Date of publication:
**12.04.2006 Bulletin 2006/15**

(51) Int Cl.:
*H03F 3/217* (2006.01)     *G09G 3/28* (2006.01)

(21) Application number: **05109392.0**

(22) Date of filing: **10.10.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **11.10.2004 FR 0452336**

(71) Applicant: **Thomson Licensing, Inc.
92100 Boulogne-Billancourt (FR)**

(72) Inventor: **Ploquin, Didier
92648, BOULOGNE BILLANCOURT (FR)**

(74) Representative: **Le Dantec, Claude
Thomson,
46, Quai Alphonse Le Gallo
92100 Boulogne-Billancourt (FR)**

(54) **Amplifier designed to generate a rectangular voltage signal with soft switching on a capacitive load**

(57) The present invention relates to an amplifier designed to generate a rectangular voltage signal with soft switching on a capacitive load (Cp), comprising a half-bridge structure consisting of two switches (M1, M2), which is connected between a supply terminal (VS) and a reference terminal (GND), the mid-point of said structure being connected to said capacitive load, and a soft-switching circuit with energy recovery. To limit the conduction losses in the amplifier, the soft-switching circuit with energy recovery comprises no active component, such as a diode or transistor. According to the invention, it is formed only from an inductive elements (L2) connected in series with a capacitive element (C2) between the terminals of said capacitive load. Advantageously, the inductive element comprises a saturable inductor in order to limit the conduction losses of the amplifier.

FIG.7

## Description

The present invention relates to an amplifier designed to generate a rectangular voltage signal with soft switching on a capacitive load, comprising a half-bridge structure consisting of two switches, said structure being connected between a supply terminal and a reference terminal, the mid-point of said structure being connected to said capacitive load, and a soft-switching circuit with energy recovery. The invention relates more particularly to amplifiers designed to generate high-voltage rectangular sustain or address signals in a plasma display panel.

Prior art

Conventionally, a plasma display panel comprises a plurality of cells organized in lines and columns. In the coplanar technology currently employed, each cell is provided with three electrodes:

- one column electrode, used essentially to address the cells; the column electrodes of all the cells of the panel are connected to a column driver; and
- two line electrodes, one being called the line scanning electrode used to individually address each line of cells, and the other being called the line common electrode; all the line scanning electrodes are connected, on one side of the panel, to a line driver and the line common electrodes are connected together on the other side of the panel.

In this type of panel, each cell is addressed by applying a specific high-voltage signal between its line scanning electrode and its column electrode in order to modify its state of charge. After the addressing operation, the cell can have two states of charge, namely a first state called the "excited state", which will turn the cell on during the sustain phase of the cells to follow, and a second state in which the cell will remain turned off. The cell sustain phase that follows the address phase is a period during which high-voltage rectangular signals are applied to the line scanning electrodes and to the line common electrodes. During this phase, the previously excited cells are turned on.

To generate such voltage signals, the display panel is provided with power amplifiers. The panel comprises in particular a column amplifier to generate the address signal to be applied to the column electrode of the cells and a sustain amplifier to generate the sustain signal applied to the line scanning electrode and to the line common electrode of the cells.

These amplifiers have in common the requirement to generate signals having high-voltage transitions on a very high capacitive load, equal to the equivalent capacitor of all of the cells of the panel or to the capacitance of a large part of them.

The cell sustain operation involves an enormous transfer of energy between the amplifier and the cells of the panel, which energy must necessarily be recovered. The same applies to the operation of addressing the cell columns.

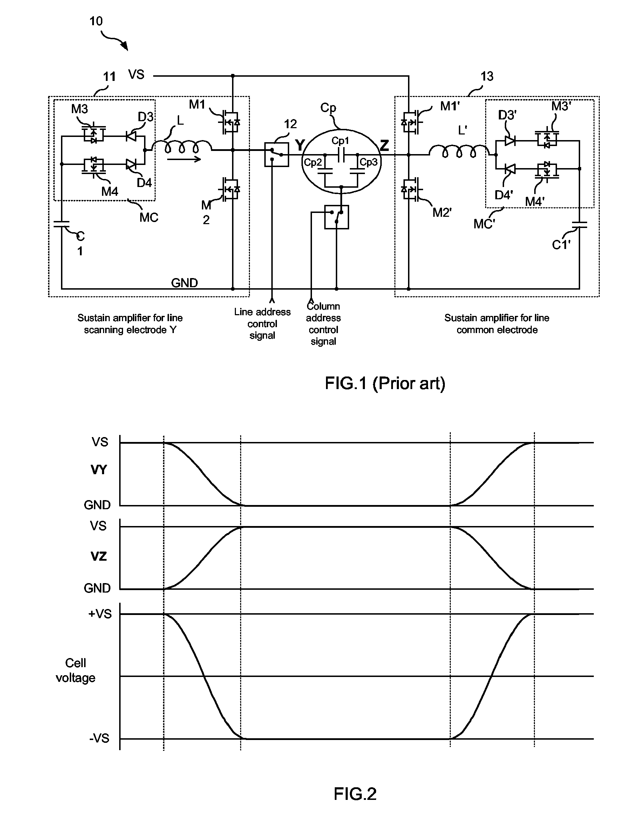

For this purpose, an energy-recovery sustain amplifier, called a Weber amplifier after the name of its inventor, has been developed. It is shown schematically in Figure 1. This amplifier 10 in fact comprises two identical amplifiers, one 11 designed to supply the line scanning electrode Y of the cells via a line driver 12 and the other 13 designed to supply their line common electrodes Z. The cells are shown in the figure by their equivalent capacitor Cp. This equivalent capacitor is in practice composed of the capacitor Cp1 present between the line scanning electrodes Y and the line common electrodes Z of the panel, of the capacitor Cp2 present between the line scanning electrodes Y and the column electrodes of the panel and finally of the capacitor Cp3 present between the line common electrodes Z and the column electrodes of the panel.

The amplifier 11 designed to supply the electrodes Y conventionally comprises switches M1 and M2 that are connected as a half-bridge structure and mounted in series between a supply terminal, which receives a very high sustain voltage VS, and a reference terminal (connected here to ground GND). These switches are operated so as to generate, on the electrode Y of the cells of the panel, a rectangular signal that alternates between the voltage VS and the potential present on the reference terminal. As shown in the figure, these switches are generally MOS transistors with their antiparallel diodes. To recover and re-inject the capacitive energy and to produce soft switching between VS and ground, the amplifier 11 includes a resonant inductor L connected in series with a switching module MC and a storage capacitor C1. These three elements are connected between the electrode Y and the reference potential. The switching module has two current conduction paths connected in parallel, each permitting the current to flow in just one direction. The first current path comprises a switch M3 connected in series with a diode D3 in order to permit current to flow towards the storage capacitor C1 when the switch M3 is closed, and thus to produce the falling edge of the output signal of the amplifier. The second current path comprises a switch M4 connected in series with a diode D4 in order to permit current to flow towards the resonant inductor L when the switch M4 is closed, and thus to produce the rising edge of the output signal.

As regards the amplifier 13, this comprises the same components as the amplifier 11, these being connected in the same way between the line common electrode Z and the reference terminal. To distinguish the components of the amplifier 11 from those of the amplifier 13 in the rest of the present description, the components of the amplifier 11 are denoted by M1, M2, L, MC, M3, M4, D3, D4 and C1, while those in the amplifier 13 are denoted by M1', M2', L', MC', M3', M4', D3', D4' and C1'.

Figure 2 shows the sustain voltage signals to be generated on the electrodes Y and Z and the resultant voltage across the terminals of the panel cells according to one mode of operation well known for obtaining good sustaining of the electrical discharges in the cells. According to this mode of operation, the transitions in the voltage signal generated on the electrode Y are synchronized with those in the voltage signal generated on the electrode Z so that the voltage across the terminals of the panel cells permanently alternates between +VS and -VS. This mode of operation has been given merely as an example in order to make the operation of the Weber circuit understood. Of course, other modes of operation exist, especially one in which the voltage transitions on the electrode Y of the cells are offset with respect to those on the electrode Z. The invention will be applicable to all these modes of operation. The equivalent capacitor Cp varies depending on the mode of operation selected.

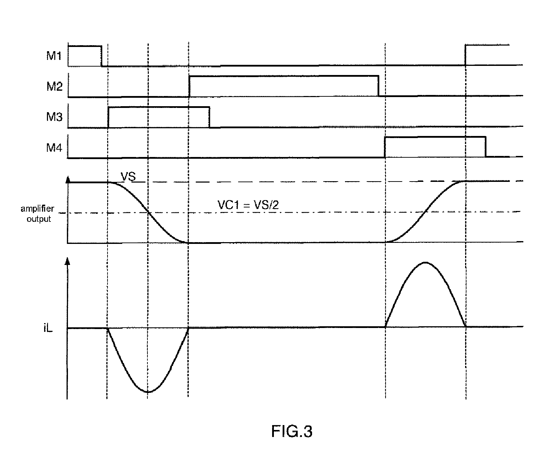

To obtain one or other of the voltage signals shown in Figure 2, the amplifier 10 is operated as illustrated in Figure 3. This figure shows more particularly the voltages for controlling the switches M1 to M4, the output voltage of the amplifier that results therefrom, and the current iL flowing through the resonant inductor L. In this figure, it is assumed that in the initial state the switches M2, M3 and M4 are open and the switch M1 is closed. The voltage on the electrode Y is therefore equal to VS. After switch M1 has been opened and switch M3 has been closed, the voltage on the electrode Y starts to drop. During this phase, the resonant circuit composed of the inductor L and the equivalent capacitor Cp is closed by the diode D3, the switch M3 and the storage capacitor C1, with the following initial conditions:

- the current iL flowing through the inductor L is zero;
- the voltage on the electrode Y is equal to VS; and
- the voltage across the terminals of the storage capacitor is equal to VS/2.

Since the capacitance of the storage capacitor C1 is much higher than that of the capacitor Cp, it may be considered that the voltage across its terminals is constant and equal to VS/2. As the current through the inductor L rises, the output of the amplifier and the voltage across the terminals of the capacitor Cp decrease along a sinusoidal portion until the voltage on the electrode Y reaches VS/2 (the point where the current iL stops rising). This first phase corresponds to a transfer of energy from the capacitor Cp to the inductor L. A reverse transfer takes place during the next phase. During this phase, the current iL decreases and the voltage on the electrode Y continues to decrease along another sinusoidal portion until reaching 0 volts (the reference potential). The diode D3 prevents the current from flowing in the reverse direction. Closing the switch M2 then allows the voltage on the electrode Y to be maintained at 0 volts. The transition of the voltage on the electrode Y from zero volts to VS is performed in the same manner, by closing the switch M4.

The main drawback of this circuit is that it comprises a large number of active components (switches and diodes) that generate conduction losses during operation of the circuit that are due to the high rms value of the current iL and to the reverse recovery losses of the diodes when they are turned off.

Invention

The invention relates to an amplifier, able to be used as a column address or sustain amplifier, capable of generating rectangular signals with soft switching, which comprises a small number of active components capable of introducing energy losses.

The invention relates to an amplifier designed to generate a rectangular voltage signal with soft switching on a capacitive load, said amplifier comprising:

- a half-bridge structure consisting of two switches, which is connected between a supply terminal and a reference terminal, the mid-point of said structure being connected to said capacitive load; and
- a soft-switching circuit with energy recovery, which is connected to said half-bridge structure, said soft-switching circuit with energy recovery being formed by an inductive element connected in series with a capacitive element between the terminals of said capacitive load. According to the invention, the inductive element comprises a first inductor connected in series with a second inductor capable of operating in saturated mode, to reduce even further the conduction losses in the amplifier. The first and second inductors are advantageously produced in one and the same coil.

According to the invention, this amplifier is included in a plasma display panel, either to generate a sustain signal on the line scanning electrodes or the line common electrodes of the cells of the panel, in order to sustain electrical discharges in the cells of the panel that were previously placed in an excited state, or to generate an address signal on the column electrodes of the cells of the panel. The capacitive load then corresponds to the equivalent capacitor of the cells of the panel.

The invention also relates to an amplifier designed to generate first and second rectangular voltage signals with soft switching on the line scanning electrodes and the line common electrodes for the cells of the plasma display panel, said amplifier comprising:

- a first half-bridge structure having two switches, which is connected between a supply terminal and a reference terminal, the mid-point of said structure being connected to said line scanning electrodes;
- a second half-bridge structure having two switches, which is connected between a supply terminal and a reference terminal, the mid-point of said structure being connected to said line common electrodes; and
- a soft-switching circuit with energy recovery, which is connected between said mid-points of said first and second half-bridge structures, said soft-switching circuit with energy recovery being formed from an inductive element connected in series with a capacitive element. According to the invention, the inductive element comprises a first inductor connected in series with a second inductor capable of operating in saturated mode in order to further reduce the conduction losses in the amplifier. The first and second inductors are advantageously produced in one and the same coil.

Drawings

The invention will be better understood on reading the description that follows, given by way of non-limiting example and with reference to the appended drawings in which:

- Figure 1, already described, shows a diagram of a sustain amplifier of the prior art;
- Figure 2, already described, shows timing diagrams illustrating the voltage signals generated by the sustain amplifier of Figure 1 in a known mode of operation of the amplifier;
- Figure 3, already described, shows control signals for controlling elements of the amplifier of Figure 1 and signals illustrating the operation of said amplifier;
- Figure 4 shows a diagram of a first amplifier according to the invention, capable of generating a rectangular voltage signal with soft switching on one or other of the electrodes of the cells of a plasma display panel in order to sustain the cells or to address the columns of cells;
- Figure 5 shows timing diagrams illustrating the control signals for controlling the amplifier of Figure 4 in order to generate a signal to be applied to the electrodes Y or Z of the cells during the sustain phase of the cells;
- Figure 6 shows timing diagrams illustrating the control signals for controlling the amplifier of Figure 4 in order to generate a signal to be applied to the column electrodes of the cells during the address phase of the cells;
- Figure 7 shows a diagram of a second amplifier according to the invention capable of generating a rectangular voltage pulse with soft switching on one or other of the electrodes of the cells of a plasma display panel in order to sustain the cells or to address the columns of cells;
- Figure 8 shows timing diagrams illustrating the control signals for controlling the amplifier of Figure 7 in order to generate a signal to be applied to the electrodes Y or Z of the cells during the sustain phase of the cells; and
- Figure 9 shows a sustain amplifier according to the invention, in which the soft-switching circuit with energy recovery is common to the electrodes Y and Z of the cells of the panel.

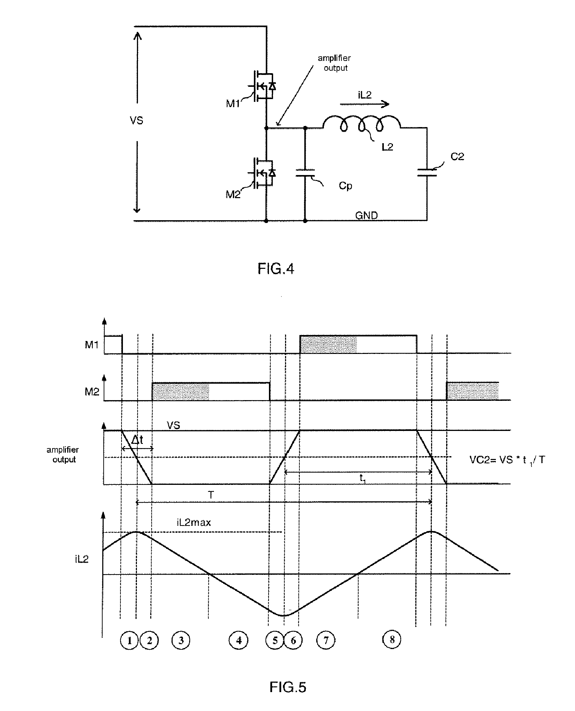

According to the invention, the circuit used for generating soft switching, while still recovering energy, is limited to an inductive element L2 connected in series with a capacitive element C2, the combination being connected to the terminals of the equivalent capacitor Cp of the cells of the panel. This circuit is shown in Figure 4 for generating a rectangular signal to be applied to the electrode Y or Z of the cells during their sustain phase or to the column electrode of the cells during their address phase.

In the case of a sustain operation, the voltage VS is the voltage, of around 200 volts, for sustaining the cells and, in the case of addressing the cell columns, the voltage VS is an address voltage of around 60 volts. The capacitance of the capacitor Cp varies depending on the mode of operation (with synchronized or unsynchronized transitions) and depending on the type of operation (address phase or sustain phase). The capacitor Cp corresponds, depending on the case, to the equivalent capacitor of the panel seen from the electrode Y or Z, or from the column electrode. For example, in the case of a synchronized-transition mode, the capacitance of the capacitor Cp is equal:

- with the electrode Y, the equivalent capacitance of the capacitors Cp2 and Cp1/2, and
- with the electrode Z, the equivalent capacitance of the capacitors Cp3 and Cp1/2

For the address phase, the capacitance of the capacitor Cp depends on the images to be displayed.

Unlike the circuit of the prior art described above, this energy recovery circuit comprises neither switching transistors nor diodes. Moreover, the inductance of the inductive element L2 is very much greater than that of the inductor L or L' of the Weber circuit of Figure 1, being 100 to 1000 times greater. Likewise, the capacitance of the capacitive element is very much greater than the capacitance of the capacitor Cp, being at least 10 times greater.

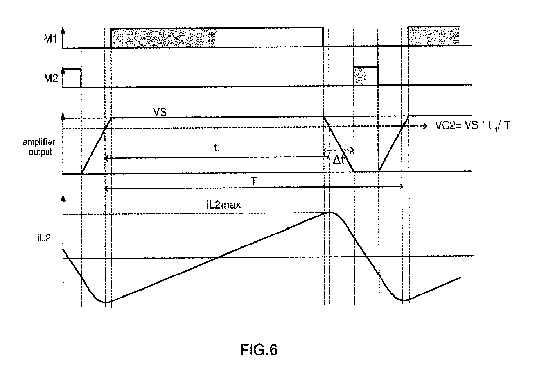

The operation of the amplifier is described more particularly with reference to Figure 5. It is made up of eight successive phases, numbered 1 to 8 in the figure.

During phases 1, 2, 5 and 6, the switches M1 and M2 are open. These phases correspond to transition phases in which there is a transition in the voltage at the output of the amplifier. Phases 1, 4, 5 and 8 correspond to phases in which energy is stored in the inductor L2, and phases 2, 3, 6 and 7 are phases in which this energy is recovered from the cells of the panel.

More particularly, the inductor L2 resonates with the load capacitor C2 and the panel capacitor Cp during phases 1, 2, 5 and 6. Since C2 is very much greater than Cp, it may be considered that L2 resonates with Cp. At the end of phases 1 and 5, the inductor L2 is charged with a maximum current $iL2_{max}$. It then decreases during the next phase. This current changes direction at the end of phases 3 and 7.

During phases 3 and 7, the switching transistors M1 and M2 may either be open or closed. If they are open, their intrinsic diodes then allow the current to flow. The areas shaded grey in the timing diagrams of Figure 6 indicate those periods in which it does not matter whether the state of the switching transistors of the amplifier is open or closed.

With this circuit, the losses are essentially limited to the conduction losses of the current iL2 and possibly to losses associated with the electrical discharge currents in the gas of the cells, depending on the characteristics and the operating mode of the panel.

To calculate the values of the components, since it may be considered that the capacitance of the capacitor C2 is very much greater than that of the panel capacitor Cp, it may be assumed that the fluctuation in the voltage across the terminals of the storage capacitor C2 is small. The voltage VC2 across the terminals of the capacitive element C2 is constant and equal to $VS \times t_1/T$, $t_1/T$ defining the duty cycle of the signal, T being the period of the output signal of the amplifier and $t_1$ being the time interval between two consecutive instants when the voltage across the terminals of L passes through zero, encompassing phases 7 and 8 when the switch M1 is closed.

Moreover, during the transitions of duration $\Delta t$, it may be considered with a first approximation that iL2 is constant and equal to $iL2_{max}$; $\Delta t$ can then be taken equal to $Cp \times VS/iL2_{max}$, where $iL2_{max}$ depends on VS and LZ. More precisely:

$$iL2_{max} = T. \frac{VS}{L2} . \frac{x(1-x)}{2},$$

where $x = t_1/T$ and $iL2_{max}$ determines the slope of the transitions.

To generate a square signal as shown in Figure 5, $t_1 = T/2$ and the positive and negative slopes of the current iL2 are symmetrical.

To generate a rectangular signal for an operation to address the columns of cells, $t_1 \neq T/2$, as shown in Figure 6. The current iL2 is still centred on 0, but the positive and negative slopes of this current are no longer symmetrical. In the example shown in Figure 6, where $t_1 > T/2$, the negative slope of the current iL2 is greater, in absolute value, than the positive slope since it is produced with a voltage across the terminals of the inductor equal to VC2 which is higher than that during the positive slope.

This amplifier has in particular the following advantages over the Weber amplifier:

- the structure of the amplifier is simplified, as it comprises fewer passive components. This therefore makes it possible to reduce the actual cost of the circuit, to reduce the size of the circuit on silicon, and to improve the reliability thereof; and

- there are few conduction losses during the transitions, since the corresponding current flows only through passive components.

On the downside, since the rms current iL2 flowing through the circuit is very high, the conduction losses outside the voltage transition phases are correspondingly higher.

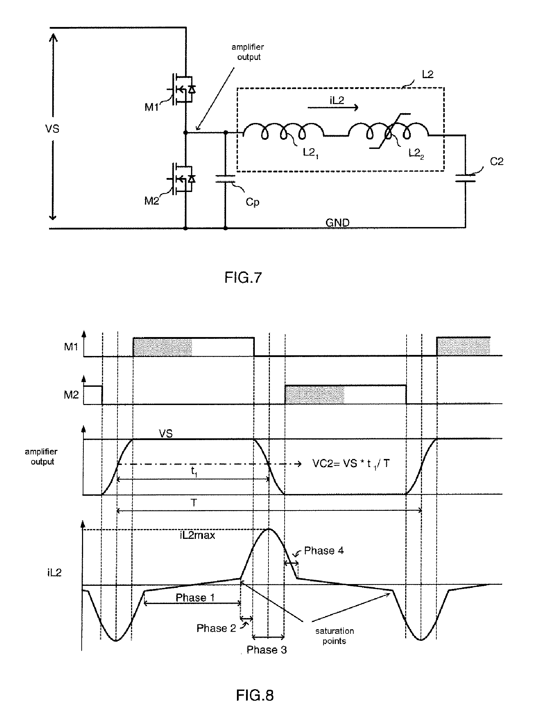

An improved embodiment, allowing these conduction losses to be reduced, is shown in Figure 7. In this embodiment, the inductive element L2 comprises two inductors connected in series, namely an inductor $L2_1$ of low value and an inductor $L2_2$ of high value capable of operating in saturated mode. In saturated mode, an inductor behaves like an air inductor (with no magnetic material). The inductor $L2_2$ acts in the present case like an automatic switch. Before saturation, little current flows through it and, after saturation, a high current flows through it. In the rest of the description, L2 denotes both the inductive element L2 and the inductance of this inductor.

In unsaturated mode, the inductor L2 acts as an inductor with an inductance $L2_2$ ($L2_1$ being very small compared

with L2$_2$) and in saturated mode as an inductor of inductance L2$_1$ (L2$_2$ is close to 0). The operation in unsaturated or saturated mode depends on the current iL2 flowing through L2.

The operation of the amplifier of Figure 7 is illustrated with reference to Figure 8. This figure shows the control signals for controlling the transistors M1 and M2, the voltage signal generated by the amplifier, and the current iL2 flowing through the inductors L2$_1$ and L2$_2$.

The half-period of operation of the current iL2 is divided into four consecutive operating phases denoted 1 to 4.

During phase 1, the switch M1 is closed and the switch M2 is open. The output voltage of the amplifier is equal to VS and the current flowing through the inductor L2 is controlled by the inductor L2$_2$ of higher inductance. Thus, the current flowing through one of the switches of the half-bridge structure is much smaller, which allows the conduction losses to be reduced. The voltage across the terminals of the inductor L2 is essentially that across the terminals of the inductor L2$_2$.

At the start of phase 2, the inductor L2$_2$ saturates. The circuit is then controlled by the inductor L2$_1$, and the current iL2 then increases linearly while the switch M1 remains closed.

Phase 3 then starts when the two switches M1 and M2 are open. The inductor L2$_1$ then resonates with the capacitor Cp, and the output voltage over the amplifier starts to fall along a sinusoid portion. In the middle of phase 3, the voltage across the terminals of the inductor L2 is reversed and the current through it decreases. After this phase, the output voltage of the amplifier reaches 0 volts (a reference potential).

At the start of phase 4, the current through the inductor L2 continues to fall linearly, whether the switch M2 is open or closed owing to its intrinsic diode (the area shaded grey). M2 must then be closed before the current becomes zero (end of the area shaded grey). After this phase, the inductor L2$_2$ is no longer saturated. A phase symmetrical with phase 1 then starts.

The choice of inductor L2$_2$ is of paramount importance. A suitable magnetic material has to be chosen and the number of turns needed has to be calculated. The number of turns of L2$_2$ may be defined in the manner below.

During each operating phase, for example during phase 1 of Figure 8:

$$V_{L2_2} = n\,Ae\,\frac{\Delta B}{\Delta t_{ph1}},$$

in which:

A$_e$ is the effective cross section of the magnetic material;
$\Delta$B is the change in magnetic induction during this phase; and
$\Delta t_{ph1}$ is the duration of phase 1.

During this phase, the voltage across the terminals of L2$_2$ is equal to VS/2 and the magnetic induction varies between +B$_{sat}$ and -B$_{sat}$ (or vice versa), hence:

$$\frac{VS}{2} = n\,A_e\,\frac{2\,B_{sat}}{\Delta t_{ph1}}$$

$$\rightarrow\ n = \frac{VS\,\Delta t_{ph1}}{4\,B_{sat}\,A_e} \qquad\qquad (1)$$

B$_{sat}$ and A$_e$ are variables that depend on the magnetic material employed. The number of turns of the inductor L2$_2$ is thus calculated from Equation (1). Having chosen the material, it is necessary to ensure that the magnetization cycle is sufficiently rectangular so that the saturation is not "soft" and that the current iL2 at the points of saturation is low (in order to reduce the intensity of the rms current). In addition, the area of this cycle must be small in order to avoid hysteresis losses.

Advantageously, the inductors L2$_1$ and L2$_2$ are produced in one and the same coil, provided that the number of turns of the coil and the effective cross section of the magnetic material are adjusted accordingly. For example, if the number of turns n calculated as described above is not suitable for the coil L2$_1$, which corresponds to the inductance of the inductor L2 when in saturated mode, it is possible to add an additional coil in series with L2. However, it is also possible to readjust the number of turns n and the cross section A$_e$.

For example, if the number of turns n calculated for phase 1 is too large for the following phases, it is sufficient to reduce this number and to consequently increase the cross section $A_e$ so that Equation 1 is still satisfied.

For example, if the number of turns calculated for phase 1 is 10 and if $L2_1$ is four times too high for phases 2, 3 and 4, it suffices to half the number of turns n and to double the cross section $A_e$.

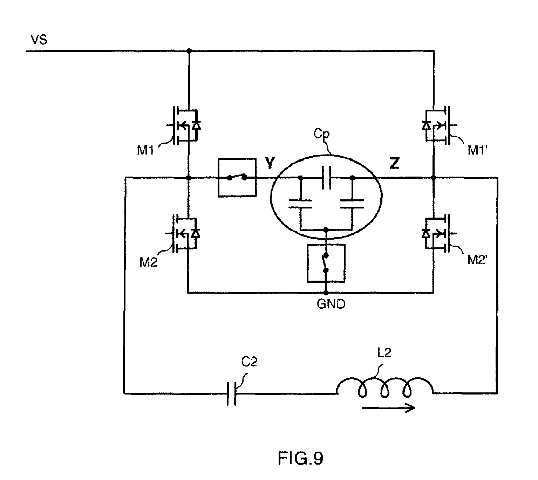

Finally, another sustain amplifier embodiment is proposed in Figure 9. In this embodiment, the circuit (L2, C2) is placed in common between the two sustain amplifiers for the electrodes Y and Z of the panel. The circuit (L2, C2) is then connected between the mid-points of the half-bridge structures (M1, M2) and (M1', M2'). With this structure, the sustain signals intended for the electrodes Y and Z necessarily have synchronous transitions in phase opposition.

## Claims

1. Amplifier designed to generate a rectangular voltage signal with soft switching on a capacitive load, said amplifier comprising:

   - a half-bridge structure consisting of two switches (M1, M2), which is connected between a supply terminal (VS) and a reference terminal (GND), the mid-point of said structure being connected to said capacitive load (Cp); and
   - a soft-switching circuit with energy recovery, which is connected to said half-bridge structure, said soft-switching circuit with energy recovery being formed by an inductive element (L2) connected in series with a capacitive element (C2) between the terminals of said capacitive load,

   **characterized in that** said inductive element (L2) comprises a first inductor ($L2_1$) connected in series with a second inductor ($L2_2$) capable of operating in saturated mode.

2. Amplifier according to Claim 1, **characterized in that** said first and second inductors ($L2_1$, $L2_2$) are produced in one and the same coil.

3. Amplifier according to Claim 1 or 2, **characterized in that** the ratio of the inductance of said second inductor ($L2_2$) to the inductance of said first inductor ($L2_1$) is between 100 and 1000.

4. Amplifier according to Claim 1, **characterized in that** the ratio of the capacitance of the capacitive element (C2) to the capacitance of the capacitive load (Cp) is at least greater than 10.

5. Amplifier according to one of Claims 1 to 4, **characterized in that** it is included in a plasma display panel for generating a sustain signal on the line scanning electrodes (Y) for the cells of the panel in order to sustain electrical discharges in the cells of the panel that were previously placed in an excited state and **in that** the capacitive load is the equivalent capacitor of the cells of the panel.

6. Amplifier according to one of Claims 1 to 4, **characterized in that** it is included in a plasma display panel for generating a sustain signal on the line common electrodes (Z) for the cells of the panel in order to sustain electrical discharges in the cells of the panel that were previously placed in an excited state and **in that** the capacitive load is the equivalent capacitor of the cells of the panel.

7. Amplifier according to one of Claims 1 to 4, **characterized in that** it is included in a plasma display panel for generating an address signal on the column electrodes for the cells of the panel and **in that** the capacitive load is the equivalent capacitor of the cells of the panel.

8. Amplifier designed to generate first and second rectangular voltage signals with soft switching on the line scanning electrodes (Y) and the line common electrodes (Z) for the cells of the plasma display panel, said amplifier comprising:

   - a first half-bridge structure having two switches (M1, M2), which is connected between a supply terminal (VS) and a reference terminal (GND), the mid-point of said structure being connected to said line scanning electrodes (Y);
   - a second half-bridge structure having two switches (M1', M2'), which is connected between a supply terminal (VS) and a reference terminal (GND), the mid-point of said structure being connected to said line common electrodes (Z); and
   - a soft-switching circuit with energy recovery, which is connected between said mid-points of said first and second half-bridge structures, said soft-switching circuit with energy recovery being formed from an inductive element (L2) connected in series with a capacitive element (C2),

**characterized in that** said inductive element (L2) comprises a first inductor (L2$_1$) connected in series with a second inductor (L2$_2$) capable of operating in saturated mode.

9.   Amplifier according to Claim 8, **characterized in that** said first and second inductors (L2$_1$, L2$_2$) are produced in one and the same coil.

**FIG.1 (Prior art)**

Sustain amplifier for line scanning electrode Y

Line address control signal

Column address control signal

Sustain amplifier for line common electrode

**FIG.2**

M1

M2

M3

M4

VS

amplifier output

VC1 = VS/2

iL

FIG.3

FIG.4

FIG.5

FIG.6

EP 1 646 143 A1

FIG.7

FIG.8

13

FIG.9

**European Patent Office**  **EUROPEAN SEARCH REPORT**

Application Number

EP 05 10 9392

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,X | US 2005/190125 A1 (IKEDA SATOSHI ET AL) 1 September 2005 (2005-09-01) * paragraph [0080] - paragraph [0122]; figures 3-12 * | 1-9 | H03F3/217 G09G3/28 |
| A | RU 2 115 175 C1 (OBSHCHESTVO S OGRANICHENNOJ OTVETSTVENNOST'JU "MIK) 10 July 1998 (1998-07-10) * abstract * | 1,2,5-9 | |
| A | US 6 483 490 B1 (LO SHIN-TAI) 19 November 2002 (2002-11-19) * column 5, line 35 - column 7, line 34; figures 7,8 * | 1-9 | |
| A | MAKSIMOVIC D ED - INSTITUTE OF ELECTRICAL AND ELECTRONICS ENGINEERS: "A MOS gate drive with resonant transitions" PROCEEDINGS OF THE ANNUAL POWER ELECTRONICS SPECIALISTS CONFERENCE. MASSACHUSETTS, 25 - 27 JUNE, 1991, NEW YORK, IEEE, US, vol. CONF. 22, 24 June 1991 (1991-06-24), pages 527-532, XP010048340 ISBN: 0-7803-0090-4 * page 527 - page 532; figures 2-4 * | 1,9 | |
| A | LAU W-H ET AL: "REALIZATION OF DIGITAL AUDIO AMPLIFIER USING ZERO-VOLTAGE-SWITCHED PWM POWER CONVERTER" IEEE TRANSACTIONS ON CIRCUITS AND SYSTEMS I: FUNDAMENTAL THEORY AND APPLICATIONS, IEEE INC. NEW YORK, US, vol. 47, no. 3, March 2000 (2000-03), pages 303-311, XP001072662 ISSN: 1057-7122 * page 304 - page 309; figures 2-6 * | 1,8 | TECHNICAL FIELDS SEARCHED (IPC) H03F G09G |

The present search report has been drawn up for all claims

| Place of search | Date of completion of the search | Examiner |
|---|---|---|
| The Hague | 23 January 2006 | Fedi, G |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 05 10 9392

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2006

| Patent document cited in search report | | Publication date | Patent family member(s) | | Publication date |
|---|---|---|---|---|---|
| US 2005190125 | A1 | 01-09-2005 | NONE | | |
| RU 2115175 | C1 | 10-07-1998 | NONE | | |
| US 6483490 | B1 | 19-11-2002 | CN 1314670 A | | 26-09-2001 |
| | | | TW 480468 B | | 21-03-2002 |

EPO FORM P0459

For more details about this annex : see Official Journal of the European Patent Office, No. 12/82